(19) **Europäisches Patentamt / European Patent Office / Office européen des brevets**

(11) **EP 1 903 004 A1**

(12) **EUROPEAN PATENT APPLICATION**
published in accordance with Art. 153(4) EPC

(43) Date of publication:
**26.03.2008 Bulletin 2008/13**

(51) Int Cl.:
*C01B 31/02* (2006.01)   *B82B 1/00* (2006.01)

(21) Application number: **06732539.9**

(22) Date of filing: **12.05.2006**

(86) International application number:
**PCT/JP2006/309558**

(87) International publication number:
**WO 2006/121155 (16.11.2006 Gazette 2006/46)**

(84) Designated Contracting States:
**DE NL**

(30) Priority: **12.05.2005 JP 2005140438
30.09.2005 JP 2005288497**

(71) Applicants:
• **Japan Science and Technology Agency
Kawaguchi-shi,
Saitama 332-0012 (JP)**
• **National University Corporation Hokkaido
University
Sapporo-shi, Hokkaido 060-0808 (JP)**

(72) Inventors:
• **MURAKOSHI, Kei
Sapporo-shi,
Hokkaido 0050018 (JP)**
• **TAKEDA, Norihiko
Sapporo-shi,
Hokkaido 0010023 (JP)**

(74) Representative: **Turner, James Arthur
D Young & Co
120 Holborn
London EC1N 2DY (GB)**

(54) **CARBON NANOTUBE COMPOSITION, PROCESS FOR PRODUCING THE SAME, ARRAY AND ELECTRONIC DEVICE**

(57)    The present invention attempts to establish a method for surface-fixing single-walled carbon nanotubes having a desired chirality highly selected from among the single-walled carbon nanotubes having various chiralities, and utilizes the method to provide an array of the carbon nanotubes for electronic devices. The present invention attempts also to provide a carbon nanotube composition including carbon nanotubes having a single chiral vector (n, m) at a purity of more than 50% based on the unit of number wherein n and m are integers, and a method for manufacturing the same.

*FIG. 1*

Chiral vector : $C_h = n\vec{a} + m\vec{b}$
when
$(n-m) = 3q$ metallic SWNT
$(n-m) \neq 3q$ semiconducting SWNT
(where q is integer)

○ metallic
● semiconducting

## Description

TECHNICAL FIELD

The present invention relates to a carbon nanotube composition containing carbon nanotubes with a single chirality at high purity and a method for manufacturing the composition. The invention relates also to an array of carbon nanotubes fixed on a solid-state substrate surface by a manufacturing method of the present invention and to electronic devices using the array.

BACKGROUND ART

A method for locally fixing single-walled carbon nanotubes (hereinafter, simply referred to as SWNTs) includes a SWNT growth method, by which SWNTs are grown on a substrate surface by a CVD method (refer to non-patent documents 1-7). This method involves placing a metal catalyst at an intended position followed by supplying a material compound thereon to synthesize SWNTs. It has not been achieved, however, that a certain number of SWNTs are structure-selectively fixed at given points.

Generally, the individual SWNTs with diameters ranging from 0.7 to 1.8 nm, which are synthesized by any of CVD, arc-discharge, laser ablation methods and the like, have their own unique electronic structures and band gap energy levels because they take the form of a mixture of semi-conductive/metallic tubes with about 140 types of chiral vectors (n, m).

Previous studies have demonstrated that these SWNTs with different chiral vectors (n, m) have various fermi potential levels in a solution.

Conventionally, no technique has been established for fixing only a certain type of SWNTs with a given chiral vector (n, m), selectively among these SWNTs with various chiral vectors (n, m), on a substrate surface.

Specifically, some of carbon nanotubes may have both metallic and semi-conductive properties depending on their diameters and helix structures.
These physical properties of the carbon nanotubes are quite different depending on the structures thereof.

In addition, carbon nanotubes are materials expected to develop applications in electronics and energy fields as the next-generation material for electronic devices.

For carbon nanotubes to apply to electronic devices and the like, it is desired that the carbon nanotubes are formed electrically contiguous to metallic electrodes.

The method of the prior art for fixing SWNT on an electrode made of a metal or any other material includes a method involving applying a dilute SWNT dispersion solution and an electrophoresis method (direct current or alternating current; refer to the non-patent documents 8 and 9 for the method using direct current electrophoresis. Refer to the non-patent documents 10 to 15 for the method using alternating current electrophoresis).

In the method by electrophoresis, two metallic electrodes are immersed in an SWNT-containing solution and applied with a given level of potential between them by direct current or alternating current to deposit SWNT on either one or both of them, or between them.

A previous study has reported that the tube deposited by alternating current electrophoresis had an increased ratio of metallic tubes, and thus this method is studied as a method for separating semi-conductive tubes from metallic tubes. For example, there has been reported a method using alternating current electrophoresis to bind SWNT between gold electrodes (refer to the non-patent document 16).

Moreover, there has been reported another method, which involves fixing SWNTs on a chemically modified conductive substrate (refer to the non-patent documents 17 and 18).

Furthermore, there has been reported an additional method, which involves floating-potential alternating electrophoresis to deposit SWNTs between electrodes (refer to the non-patent document 19).

Besides, there has been reported a further other method, which involves repeating a step of dispersion and centrifugal separation to separate between metallic and semi-conductive tubes, resulting in concentrated metallic tubes (refer to the non-patent document 20).

[non-patent document 1] Y.Li, W.Kim, Y.Zhang, M.Rolandi, D.Wang J.Phys.Chem.B 2001, 105, 11424-11431
[non-patent document 2] Y.Zhang, Y.Li, W.Kim, D.Wang, H.Dai Appl.Phys.A 2002, 74,325-328
[non-patent document 3] Y.Li, J.Liu, Y.Wang, Z.L.Wang Chem.Mater.2001, 13, 1008-1014
[non-patent document 4] Y.Murakami, Y.Miyauchi, S.Chiashi, S.Maruyama Chem.Phys.Lett.2003,377,49-54
[no-patent document 5] Y.Murakami, S.Chiashi, Y.Miyauchi, M.Hu, M.Ogura, T.Okubo, S.Maruyama Chem. Phys.Lett.2004,385,298-303
[non-patent document 6] K.Hata, D.N.Futaba, K.Mizuno, T.Namai, M.Yumura, S.Iijima Science 2004, 306,1362-1364
[non-patent document 7] E.W.Wong, M.J.Bronikowski, M.E.Hoenk, R.S.Kowalczyk, B.D.Hunt Chem.Mater. 2005,17,237-241
[non-patent document 8] J.Liu, A.G.Ringzler, H.Dai, J.H.Hafner, R.K.Bradley, P.J.Boul, A.Lu, T.Iverson, K.Shelimov, C.B.Huffman, F.Rodriguez-Macias, Y.-S. Shon, T.R.Lee, D.T.Colbert, R.E.Smalley, Science, 1998,280,1253
[non-patent document 9] P.V.Kamat, K.G.Thomas, S.Barazzouk, G.Girishkumar, K.Vinodgopal, D.Meisel,J. Am. Chem. Soc.,2004,126,10757
[non-patent document10] R.Krupke, F.Hennrich, H.v.Lohneysen, M.M.Kappes, Science,2003,301,344
[non-patent document11] D.L.Fan, F.Q.Zhu, R.C.Cammarata, C.L.Chien, Appl. Phys. Lett.,2004,85,P.4175
[non-patent document 12] C.K.M.Fung, V.T.S.Wong, R.H.M.Chan, W.J.Li,IEEE Transactions on Nanotechnology,2004,3,395

[non-patent documents 13] Z.Chen, W.Hu, J.Guo, K.Saito, J. Vac. Sci. Technol. B,2004,22,776

[non-patent document14] Z.Chen, Y.Yang, Z.Wu, G.Luo, L.Xie, Z.Liu, S.Ma, W.Guo, J. Phys. Chem. B, 2005,109,5743

[non-patent document 15] D.S.Lee, D.W.Kim, H.S.Kim, S.W.Lee, S.H.Jhang, Y.W.Park, E.E.B.Campbell, Appl. Phys. A,2005,80,5

[non-patent document 16] Z.Chen, Y.Yang, F.Chen, Q.Qing, Z.Wu, Z.Liu, J.Phys.Chem.B2005,109,11420

[non-patent document 17] J.Liu, M.J.Casavant, M.Cox, D.A.Walters, P.Boul, W.Lu, A.J.Rimberg, K.A.Smith, D.T.Colbert, R.E.Smalley, Chem. Phys. Lett.,1999, 303,125 [non-patent document8] M.-S.Jung, Y.-K.Ko, D.-H.Jung, D.-H.Choi, H.-T.Jung, J.-N.Heo, B.-H.Sohn, Y.-W.Jin, J.Kim, Appl.Phys.Lett.2005,87,013114

[non-patent document 19] L. Dong, V. Chirayos, J. Bush, J.Jiao, V.M.Dubin, R.V.Chebian, Y.Ono, J.F.Conley Jr., B.D.Ulrich, J.Phys.Chem.B2005,109,13148

[non-patent document20] Y.Maeda, S.Kimura, M.Kanda, Y.Hirashima, T.Hasegawa, T.Wakahara, Y.Lian, T.Nakahodo, T.Tsuchiya, T.Akasaka, J.Lu, X.Zhang, Z.Gao, Y.Yu, S.Nagase, S,Kazaoui, N.Minami, T.shimizu, H.Tokumoto, R.Saito, J.Am.Chem.Soc.2005,127,10287

DISCLOSURE OF THE INVENTION

Meanwhile, it has been progressively elucidated that the optical and electric properties of SWNTs depend on their diameters.

However, previously proposed methods for manufacturing SWNTs, which have not intended to keep the SWNTs in a uniform diameter, have deposited selectively no SWNT with desired properties at their desired points.

Previously proposed methods by electrophoresis, which control only a relative potential difference between two electrodes, have formed no SWNTs kept in a uniform diameter.

Similarly, a method using a chemically-modified conductive substrate, as proposed by the above nonpatent document 17, do not intend to form SWNTs kept in a uniform diameter.

To resolve the problem mentioned above, the present invention provides a method for manufacturing a carbon nanotube composition with a desired chiral vector (n, m) and desired properties, which allows formation of the carbon nanotubes fixed at their desired points with a high selectivity, and a carbon nanotube composition with the desired properties obtained by such a manufacturing method.

The present invention also provides a carbon nanotube array for electronic devices, which can be obtained by the method for manufacturing the carbon nanotube composition.

The present inventers have examined the fact that the band structures vary depending on a chiral vector (n, m), found that SWNTs could be excited by light and then subjected to charge-transfer reaction to immobilize single SWNTs or one or a few pure SWNTs position-selectively on the surface in a solid substrate or in a solution with high reproducibility, and reached the present invention.

The present invention employs laser beam or the like as a light source for exciting the carbon nanotube to use photo-induced electron transfer reaction. For solid substrate, on which carbon nanotubes are fixed, various materials are available including insulators such as glass, semiconductors such as silicone, and metals such as gold. The positions, at which the carbon nanotubes are fixed, may be selected at a high accuracy by monitoring light-irradiated spots with a CCD camera and the like. The monochromatic laser beam can be used as an excitation light source to react SWNTs having a band gap corresponding to photon energy of the laser beam selectively with a chemical species in a solution. From among the carbon nanotubes having several kinds of chiralities which are simultaneously excited by a monochromic laser beam, the reduction potential and activation energy of a chemical species to react with the tubes can immobilize selectively SWNTs having a single kind or a few kinds of chiralities. On the other hand, a white light source can be used to immobilize simultaneously a plurality of SWNTs having various hand gaps.

As mentioned above, according to the present invention, SWNTs having a single kind or a few kinds of chiralities may be selectively fixed, and thus, SWNTs having a desired single kind or a few kinds of chiralities may be selectively obtained by adjusting the manufacturing conditions.

For example, carbon nanotube compositions composed of a tube having a longitudinal length (L) of less than 200 nm, those composed of a tube having a longitudinal length (L) of 1 $\mu$m or more, and those composed of a tube having a longitudinal length (L) of 200 nm or more and less than 1 $\mu$m may be selectively obtained.

According to the present invention, the following carbon nanotube compositions may be provided:

(1) A carbon nanotube composition comprising carbon nanotubes having a single chiral vector (n, m) at a purity of more than 50% based on the unit of number, where n and m are integers;
(2) The carbon nanotube composition as defined in Term (1), comprising the carbon nanotubes at a purity of 90% or more based on the unit of number;
(3) The carbon nanotube composition as defined in Term (1), wherein the absolute value for n is smaller than 100 and the absolute value for m is three or larger and smaller than 100;
(4) The carbon nanotube composition as defined in Term (1), wherein n and m are different, m is not 0 (zero), and the tubes have a clockwise helix structure;

(5) The carbon nanotube composition as defined in Term (1), wherein n and m are different, m is not 0 (zero), and the tubes have a counter-clockwise helix structure;

(6) The carbon nanotube composition as defined in Term (1), wherein the spectrum corresponding to a Radial Breathing Mode (RBM) observed within a wavenumber region of 100 to 600 cm-1 has a half bandwidth of smaller than 8 cm$^{-1}$ in laser-induced resonance Raman scattering measurement.

(7) The carbon nanotube composition as defined in Term (1), wherein the tubes have a single diameter;

(8) The carbon nanotube composition as defined in Term (7), wherein the diameter is 0.3 to 10 nm;

(9) The carbon nanotube composition as defined in Term (1) or (7), wherein the composition exists as a haploid of the carbon nanotubes;

(10) An array of the carbon nanotube composition as defined in Term (1) or (9), wherein the array is fixed on a solid substrate;

(11) The array of the carbon nanotube composition as defined in Term (10), wherein the solid substrate is an insulating substrate, a semiconductor substrate, or a metallic substrate;

(12) An electronic device comprising the array as defined in Term (10);

(13) A method for manufacturing a carbon nanotube composition composed of tubes having a desired single chirality, comprising the steps of:

(a) preparing a solution containing carbon nanotubes; and
(b) irradiating the solution with a laser beam,

wherein

the carbon nanotube composition comprises carbon nanotubes having a single chiral vector (n, m) at a purity of more than 50% based on the unit of number, where n and m are integers;

(14) The method as defined in Term (13), wherein the carbon nanotube composition comprises carbon nanotubes having a single chiral vector (n, m) at a purity of 90% or more based on the unit of number;

(15) The method as defined in Term (13), wherein the carbon nanotubes in the step (a) have a plurality of different chiralities;

(16) The method as defined in Term (13), wherein the solution is an aqueous dispersion or an aqueous solution of the carbon nanotubes, which contains a metal ion and an electron donor;

(17) The method as defined in Term (13), wherein the laser beam is a laser beam corresponding to a transition energy between bands of desired carbon nanotubes;

(18) The method as defined in Term (16), wherein the step (b) is conducted in the presence of a magnetic field using magnetized metal ions as the metal ions;

(19) The method as defined in Term (13), further comprising a step (c) for separating and purifying the carbon nanotube composition deposited by the step (b);

(20) The method as defined in Term (13), wherein the solution with the substrate immersed therein is irradiated with the laser beam in the step (b);

(21) The method defined in Term (13), further comprising the step of supplying the substrate using a conductor with the solution and applying the conductor with a given potential in the step (b);

(22) The method as defined in Term (21), wherein the conductor is applied with a given potential to have a controlled surface potential of -3.0 V to +2.0 V against that of a standard hydrogen electrode;

(23) The method as defined in Term (13), wherein any conductive material selected from a noble metal, a base metal, indium tin oxide, glassy carbon, Highly Oriented Pyrolytic Graphite (HOPG), and silicon, is used for the substrate.

(24) The method as defined in Term (16), wherein the metal ion is the ion species of a transition metal element selected from the group consisting of alkali metal elements, alkali earth metal elements, IIIA to VIIA group elements, VIII group elements, and IB group elements, or of a rare earth element;

(25) The method as defined in Term (16), wherein the electron donor is a material selected from the group consisting of alcohols, amines, arginine, benzaldehyde, hydrazine, carboxylates, amino acids, toluene, alkyl benzens, terpenes, ethers, silanes, and thiols.

(26) A carbon nanotube composition manufactured by the method as defined in Term (13); and

(27) An array formed by the method as defined in Term (20),

wherein a carbon nanotube composition is fixed on a solid substrate.

According to the present invention, only SWNTs having a desired chiral vector (n, m) may be fixed on the surface of a solid substrate highly selectively from among those having various chiralities.

According to the present invention, moreover, carbon nanotube arrays formed by surface immobilization as mentioned above may be provided for electronic devoices.

According to the present invention, furthermore, a conductor can be used as a substrate and applied with a given potential to concentrate a carbon nanotube composition having a given diameter at an intended position on the substrate. Accordingly, carbon nanotube electrodes can be formed to comprise a carbon nanotube composition having a give diameter on a conductor. Namely, specific carbon nanotube compositions can be uniformly formed on a conductor.

Accordingly, for example, it is possible that carbon nanotube electrode catalysts having uniform current-potential characteristics, high-sensitive molecular sensors and biological material sensors having more controlled sensitivities, photoelectric converters (photodiodes and the like) having uniform optical absorption bands, light sensors having more uniform optical response, photoconductive materials having more uniform response, electrolytic discharge devices having controlled characteristics, capacitors composed of carbon nanotubes having a given diameter, and the like are provided.

BRIEF DESCRIPTION OF DRAWINGS

FIG. 1 is a schematic diagram illustrating a chiral vector ch = (n, m) which specifies a carbon nanotube.
FIG. 2 shows a reaction mechanism expected between a carbon nanotube and a metal ion in the present invention.
FIG. 3 is schematic diagram of a typical Raman spectrum drawn by a Raman spectrum detector and carbon nanotubes used in the present invention.
FIG. 4 shows the Raman spectrum (785 nm of Raman excitation light source) of SWNTs photo-fixed in the presence of SDS dispersion SWNT (pristine, upper left) and Fe (II) ions (left), or Mn (II) ions (right).
FIG. 5 shows a change in Raman scattering peak intensity associated with light irradiation in the presence of Fe (II) or Mn (II) ions. The inserted view shows a temporal change thereof (785 nm of Raman excitation light source) in the case of Fe (II) ions.
FIG. 6 shows the image by an atomic-force microscope (AFM) of the SWNTs fixed on a substrate by light irradiation in the presence of Fe (II) ions.
FIG. 7 shows a CCD image under a light-irradiated spot in the presence of Fe (II) ions.
FIG. 8 shows an optical microscopic image of a SWNT microdot array.
FIG. 9 is a schematic configuration diagram of a potential-controlled SWNT optical deposition device.
FIG. 10 is an optical microscopic image of the SWNT concentrated on a metal electrode.
FIG. 11 is a diagram showing a temporal change in Raman scattering peak intensity and photocurrent at a potential of +0.1 V.
FIG. 12A is a diagram showing a temporal change in Raman scattering spectrum at a potential of -0.5 V. FIG. 12B is a diagram showing a temporal change in Raman scattering spectrum at a potential of 0.0 V. FIG. 12C is a diagram showing a temporal change in Raman scattering spectrum at a potential of +0.5 V.
FIG. 13 is a Raman scattering spectrum at each electrode potential.
FIG. 14 is a diagram showing a temporal change in Raman scattering spectrum at each electrode potential.

FIG. 15 is a diagram showing the relationship between the Raman scattering intensity and the electrode potential after 15 minutes light irradiation.

BEST MODE FOR CARRYING OUT THE INVENTION

Hereinafter, the present invention will be described.

It should be appreciated that throughout the present specification, any singular-form representation includes the notion of its plural form representation, unless otherwise specified. Moreover, it should be also appreciated that any term used in the specification has a meaning commonly used in the art, unless otherwise specified.

(Technical terms)

Hereinafter, the definitions, meanings, and content of technical terms especially concerning the composition of the present invention used in the specification are described.

The term "Carbon nanotube, simply referred to as CNT" used in the specification is a kind of carbon cluster represented by $C_n$ (n is an integer showing the number of carbon atoms), and indicates a structure made of one or more cylindrically-rounded graphite sheets (two-dimensionally spread carbon hexagon mesh surface formed by carbon atoms chemically bonded on a $sp^2$ hybrid orbital; commonly called graphen). The structure of a carbon nanotube is determined by physical properties such as its diameter and chiral vector (n, m) (a vector which specifies twisting level, clockwise or counter-clockwise helix and the like, wherein n and m are integers). Typical type of structures commonly known includes, but is not limited to, (5,5) arm-chair type, (9.0) zigzag type, and (9,1) chiral type.

The chiral vector (n, m) and diameter of a carbon nanotube may be determined as follows.

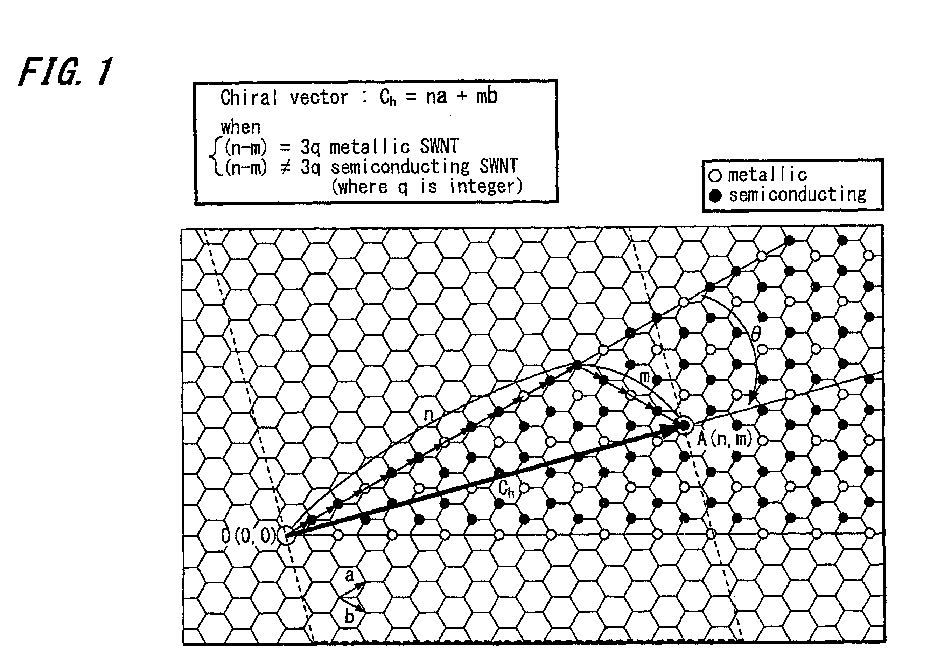

As shown in FIG. 1, unit lattice vectors a, b are assumed on one layer of graphite (graphen) with carbons formed into a hexagonal lattice structure (a honeycomb structure). As an experimental illustration, a start point O and an end point A are determined on carbon lattice points, and the graphen sheet is rounded to overlap the 0 with the A, resulting in the cylindrical structure of a carbon nanotube. In this case, a vector corresponding to the "equator" of the tube:

$$\overrightarrow{OA}$$

is called a chiral vector Ch, which is represented by a formula Ch = na+mb, and assuming that the coordinate of the start point O is (0,0), the coordinate of the end point A is (n, m) and accordingly, Ch ≡ (n, m) (wherein n and m are integers to satisfy an operation:

$$0 \leq |m| \leq n$$

) is provided. The structure of any tube may be specified in terms of n,m (excluding a length along the axis). For example, using a carbon-carbon interatomic distance a, the diameter $d_t$ of a tube may be represented as follows.

$$d_t = \frac{a\sqrt{n^2 + m^2 + nm}}{\pi}$$

The carbon nanotube may be classified into an arm-chair type tube when n=m, a zigzag type tube when m=o, and otherwise a chiral type tube having a clockwise /counter-clockwise helix, depending on the vertical section to its axis.

In addition, the tube has a metallic band structure when n-m is a multiple of three, and has otherwise a semi-conductive band structure, which have their respective unique electronic structures.

For the detail descriptions of the carbon nanotube structure, refer to, for example, "Basics and applications of carbon Nanotubes", Ri'ichiro Saito and Hisanori Shinohara, Baifukan, 2004, Chapter 1; and "Physical Propertes of Carbon nanotubes", R. Saito, G. Dresselhaus, M. S. Dresselhaus, Imperial College Press, London 1998, Chapter 3.

It should be noted that the physical property specified by the above-mentioned chiral vector (n, m) is also referred to as "chirality" in the specification. The "carbon nanotube" separated and purified in the present invention may be a "single-walled carbon nanotube (simply referred to as SWNT) composed only of a single tube, or may be a "multi-walled carbon nanotube (simply referred to as MWNT) composed of a plurality of tubes nested each other.

The "carbon nanotube composition" of the present invention indicates a composition composed of carbon nanotubes having various physical properties, and may contain a small quantity of carbon impurity and other impurity components to such an extent that the carbon nanotube may not lose the inherent nature or may be used to manufacture an array for an electronic device without losing the functions. Herein, the impurity components include amorphous carbons, metals and metal salts deposited during a manufacturing process, metallic oxides, organic substances such as dodecyl sodium sulfate, a surface active agent (SDS) used as a dispersant, alcohol used as a sacrificial electron donor, or organic materials other than metal ions serving as charge-transfer reagents (for example, 2,3-dichloro-5,6-dicyano-1,4-benzoquinone (DDQ), and 7, 7,8,8-tetracyanoquinodimethane (TCNQ)).

Unless otherwise specified, a carbon nanotube composition comprises carbon nanotubes having a single chiral vector (n, m) at a purity of more than 50%, preferably 90% or more, more preferably 95% or more, particularly preferably 99% or more, or most preferably 100% based on the unit of number. The purity represented by % is specified for the carbon nanotube structures in the carbon nanotube composition, and thus does not include the above-mentioned impurity components. The above-mentioned n and m are integers.

The structure comprising carbon nanotube having a single chiral vector at more than 50% based on the unit of number, can be referred to as a "single carbon nanotube" in the broad sense.

In the present invention, preferably, the carbon nanotubes having a single chiral vector, which compose a carbon nanotube composition, are SWNTs.

It should be noted that the above-mentioned term "carbon nanotube composition" may be interchangeably used with the term "carbon nanotube body" in the specification.

In the specification, the description "a carbon nanotube composition exists as a haploid" means that carbon nanotubes, which compose the composition, have a single chiral vector (n, m), and all (100% of) the constituents, which compose the carbon nanotube composition, are carbon nanotubes having a single chiral vector (n, m).

In the specification, the description "a carbon nanotube composition exists in the form of a bulk or aggregate" means that the constituent molecules, which compose the composition, are in the state of a bulk or aggregate themselves into the form of an aggregate.

In the specification, the description "a solution comprising a plurality of carbon nanotubes (having their respective chiralities)" means any of an organic solution, an aqueous solution, and an aqueous dispersion of a crude product which contains or is expected to contain carbon nanotubes having different chiralities (chiral vectors (n, m)) produced by three methods mentioned later, or commercially available carbon nanotubes, and if needed, also contains impurities such as a surface active agent and electron donors used for intended purification. The above-mentioned crude product may contain metals or various kinds of carbon impurities other than the produced carbon nanotubes.

An "electron donor" of the present invention means a compound which supplies the occupied level of an electron-losing carbon nanotube with another electron. The electron donor of the present invention includes, but is not limited to, alcohols, amines, arginine, benzaldehyde, hydrazine, carboxylic acids, amino acid, toluene, alkyl benzenes, terpenes, ethers, silanes, and thiols. The preferable electronic donor of the present invention is methanol.

In the specification, carbon nanotubes physically or chemically adsorbed on a substrate or a support are referred to as those "fixed" on the substrate or the support.

(Principles of the Invention)

The principles of the present invention are described below.

Carbon nanotubes having a band gap corresponding to the photon energy of excitation light are selectively reacted with chemical species (such as metal ions) in a solution, utilizing photo-induced electron transfer reaction which uses a light source of a certain wavelength such as a laser beam, as an excitation light source of carbon nanotubes. Depending on the reduction potential and activation energy of a chemical species to be reacted with, this may selectively immobilize carbon nanotubes having a single type or a few types of chiralities, from among carbon nanotubes having a plurality of chiralities simultaneously excited by a monochromatic light.

It should be noted that a white light source may be used instead of a laser beam to immobilize simultaneously a plurality of carbon nanotubes having various band gaps.

The position, at which the carbon nanotube is fixed, may be accurately selected by monitoring a light-irradiated spot with a CCD camera or the like.

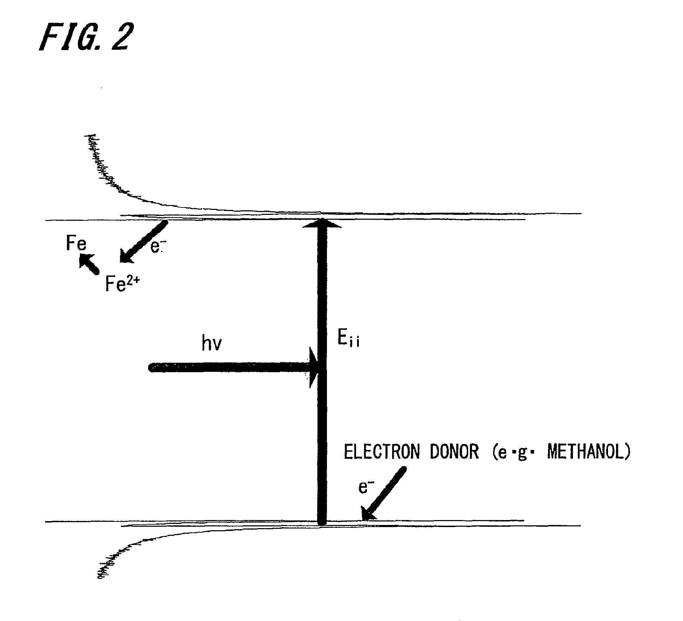

FIG. 2 shows a reaction mechanism expected to be carried out between the carbon nanotube and the metal ions in the present invention. In the figure, the reaction mechanism expected to be carried out between $Fe^{2+}$ and the electronic level of the carbon nanotube is shown as an example. Specifically, in the first step of the reaction mechanism, the carbon nanotube is irradiated with excitation light to cause electronic transfer from occupying energy level to non-occupying energy level between a band gap corresponding to the energy of the excitation light. Then, the transferred electron passes to the oxidization-reduction potential of a metal ion at a position nearer than the occupying energy level (herein, the oxidization-reduction potential of $Fe^{2+}/Fe$), rather than passing back from the non-occupying energy level to the occupying energy level. Accordingly, $Fe^{2+}$ turns into Fe to deposit on the carbon nanotube. The electron lost from the occupying energy level of the carbon nanotube is compensated with another electron which methanol as an electron donor supplies to the occupying energy level of the carbon nanotube.

(Raman scattering of carbon nanotubes)

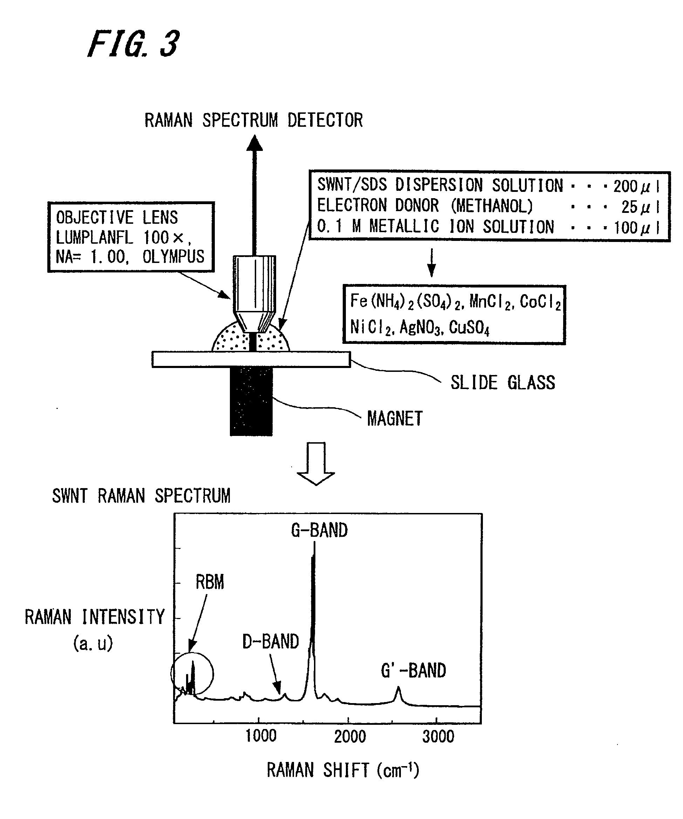

The carbon nanotube fixed on a substrate may be qualified and quantified by laser-induced resonant Raman scattering measurement. Schematic diagrams of a Raman spectrum detector and of the typical Raman spectrum of a carbon nanotube are shown in FIG. 3.

The Raman spectrum of a carbon nanotube usually arises from any of four types of modes, namely RBM (Radial Breathing Mode), D-band, G-band, and G'-band.

Among these four types of modes, the radial breathing mode (RBM) can be particularly noticed to have a peak for examining the deposition behavior and selectivity of the carbon nanotubes. The peak in the RBM mode may be observed in a wave number region of 100-600 $cm^{-1}$.

The peak in the RBM has a position which varies depending on the type of the carbon nanotube, especially the chiral vector or the diameter of the carbon nanotube. Therefore, the diameter of the carbon nanotube fixed on a substrate may be determined based on the position of the observed peak.

In addition, from a peak Raman intensity, the rough amount of a carbon nanotube fixed on a substrate may be determined.

(Brief Descriptions of the Invention)

In the present invention, any separated and purified carbon nanotube and any manufactured carbon nanotube composition may be made of pure carbon nanotubes, or may be substituted with any appropriate substituent within the comprehension by those in the art in order to develop the solubility of the carbon nanotube in an aqueous or organic solvent.

Preferably, the carbon nanotube is a saturated or unsaturated carbon chain molecule having a carboxyl or amino group as a substituent in a molecule, and has its surface modified through covalent bond, ion bond, hydrogen bond, or intermolecular interaction.

The carbon nanotubes dispersed in a dispersion, which composes a carbon nanotube composition manufactured in the present invention, may be produced typically by three methods mentioned below.

A) Arc discharge

Arc discharge was used to produce carbon nanotubes at the earlier stage. Two graphite bars are closely placed several nm apart from each other, and the graphite bars are individually connected to a strong direct current source in an inert gas environment, and power is turned on. A vigorous discharge occurs between negative and positive electrodes, the graphite bars evaporated, and a carbon cluster is obtained. This is cooled down to room temperature to deposit various kinds of materials such as carbon nanotubes, fullerene, and the like on a negative electrode. The absence of a catalyst metal may produce only MWNTs, but the catalyst metal such as Co, Ni, and Fe is added to produce SWNTs.

B) Laser evaporation

Similarly to the above-mentioned method, the graphite bars are heated in an electric furnace at almost 1200°C, and instantaneously evaporated by a Nd/YAG laser under a gently supplied argon gas at 500 Torr, to obtain SWNTs. This method allows mass production of SWNTs.

C) Chemical vapor deposition (CVD)

A substrate is place in a furnace, heated at 600°C for example, and supplied slowly with a gas (such as a methane gas) which is a supply source of carbon. The gas decomposes to release carbon atoms and recombine again into a carbon nanotube. The CVD method is useful in industrial mass-production compared with the above-mentioned two other methods, but is not suitable for SWNT production.

In the manufacturing method of the present invention, commercially available carbon nanotubes may be used as those dispersed in a dispersion, which compose a carbon nanotube composition.

Usually, the carbon nanotubes before separated are in the form of a bundle body which is an aggregate of various kinds of numerous tubes, and thus in a step of preparing a dispersion, the carbon nanotubes are dispersed to separate themselves from one another in a dispersion medium (water or the like) by a known method, for example, by coating the surfaces of carbon nanotubes with any of surface active agents such as dodecyl sodium sulfate (SDS).

The surface active agents for coating carbon nanotubes may include cationic surface active agents such as octadecylamine bromide and non-ionic surface active agents such as triton-X in addition to anionic surface active agents such as SDS. Alternatively, besides surface active agents, dispersants may be used such as deoxyribo nucleic acid (DNA) and polymers.

For the dispersion medium, water, as well as any of non-aqueous solvents may be used.

Metal ions and electron donors are contained in the dispersion medium.

For example, the carbon nanotubes are dispersed in advance in a dispersion medium such as water to prepare a carbon nanotube dispersion, and then a material containing metal ions and a material containing electron donors are added in the dispersion.

For metal ions, the ion species of transfer metals selected from a group of alkaline metal elements, alkaline earth metal elements, IIIA to VIIA group elements, VIII group elements and IB group elements, or of rare earth elements may be used.

Preferably, iron (II) ion $Fe^{2+}$ or manganese (II) ion $Mn^{2+}$ is used.

Materials containing metal ions include, for example, an aqueous ammonium ferric sulfate acidic solution and an aqueous manganese chloride solution.

For the electron donor, the aforementioned material for an electron donor, preferably methanol may be used.

The material containing the electron donor includes the aforementioned electron donor alone or its solution in water or other solvents.

In the present invention, for the material for a substrate, any material capable of forming a solid surface may be used. In particular, in consideration of electronic devices using an array of carbon nanotube compositions of the present invention, the substrate on which to immobilize the array includes, but is not limited to, insulator substrates such as glass, polymer, plastic, and silicon nitride; semiconductor substrates such as silicon, indium-doped tin oxide and graphite; and metal substrates such as gold, silver, copper, platinum, stainless steel, titanium, aluminum, and nickel. In particular, the substrate using a conductor includes a conductive substrate or an electrode plate formed on the substrate (a conductive substrate or an insulating substrate).

Moreover, in order to immobilize the carbon nanotube composition on the substrate using a conductor, the conductor is supplied with a given potential.

A manufacturing apparatus is constructed to supply the conductor serving as an electrode with a given potential.

The potential may be controlled, for example, by the following arrangement, wherein the conductor (electrode) on which to immobilize a carbon nanotube composition is set as a working electrode; a counter electrode is paired with the working electrode to polarize in the opposite direction; a reference electrode is set as a reference for exactly measuring the potential of the working electrode; and these three electrodes, that is, the working electrode, the counter electrode, and the reference electrode are connected to a potentiostat (a constant potential controller).

A flat carbon electrode made of noble metals such as gold and silver and glassy carbon, or HOPG are desirably used for the material for the working electrode and the counter electrode, and further base metals such as copper may be used depending on a condition including an electrolyte used in the dispersion solution or a potential. For the working electrode, a conductive film or the like may be used.

For the reference electrode, generally a silver-silver chloride (Ag-AgCl) electrode immersed in an aqueous saturated KCl solution is used, but any other electrode used in the electrochemical field as a reference electrode, if it is stable against polarization, may be used. Generally a silver-silver ion (Ag-Ag⁺) electrode composed of the same solvent is desirably prepared in a non-aqueous solvent.

Next, the conductor (electrode) is applied with a given potential to subject the carbon nanotube to photoreaction with the metal ion in the presence of a sacrifice electron donor such as methanol.

Now, the reaction mechanism of this photoreaction is described below.

The carbon nanotube is irradiated with an excitation light to be subjected to electron transfer from its occupying energy level to a non-occupying energy level between a band gap corresponding to the energy of the excitation light.

The transferred electron passes to the oxidization-reduction potential of metal ion at a position nearer than its occupying energy level rather than transferring back from the non-occupying energy level to its occupying energy level.

Accordingly, the metal ion receives the electron to convert itself to a metal atom and deposits on the carbon nanotube. The metal species deposits on the carbon nanotube in this way to separate the carbon nanotube from the dispersion.

On the other hand, the sacrifice electron donor such as methanol supplies the carbon nanotube with an electron, with which the occupying energy level of the tube is then compensated for the electron lost by the transfer.

By means of this reaction mechanism (photo-induced metal ion reduction reaction), the photoreaction is carried out.

For an excitation light, light controlled to have a certain wavelength, for example, light from a monochromatic light source, such as laser beam, may be used. Preferably, light having a wavelength within a visual light region to a near infrared region is used. For example, a laser beam having a wavelength of 785 nm may be used.

It should be noted that a white light source can be used instead of a monochromatic light source such a laser beam to concentrate simultaneously plural kinds of carbon nanotubes having various band gaps.

In this photoreaction, the type of the excited carbon nanotube varies depending on the band gap of the carbon nanotube corresponding to the wavelength of the excitation light.

For this reason, the wavelength of the excitation light can be selected to select the type of carbon nanotubes concentrated on a substrate.

Accordingly, the photoreaction can selectively concentrate a certain kind of carbon nanotube corresponding to the wavelength of the excitation light from among various kinds of carbon nanotubes in the dispersion solution.

Transition energy (optical gap) between van Hove singular points which characterizes the electronic structure of a carbon nanotube varies depending on the diameter of the carbon nanotube.

For this reason, a carbon nanotube, which has had a certain optical gap corresponding to photon energy of irradiated excitation light, provides a valency electron which is selectively excited into a conductive band to cause a photo-induced charge transfer reaction with the metal ion and the electron donor in the solution.

Appropriate optical lenses should be combined to converge the excitation light to a high intensity for irradiating onto the dispersion, but an appropriate intensity is desirably selected because intensity varies the selectivity of the carbon nanotube.

The potential applied to the conductor can be suitably selected to limit the kind of the carbon nanotube concentrated on the conductor through photoreaction.

Accordingly, the potential applied to the conductor can be adjusted to concentrate selectively a further specified carbon nanotube, from among plural kinds of carbon nanotubes excited by the excitation light of the same wavelength.

The potential applied to the conductor is preferably controlled so that the conductor may have a surface potential within a range of -3.0 to +2.0 V in reference to a standard hydrogen electrode.

The ion of a magnetic metal (Fe, Co, Ni or rare earth elements) is used as the metal ion, and further a magnet (a permanent magnet or electromagnet) is used to form a magnetic field for attracting the magnetic metal during photo-irradiation, allowing to facilitate concentration of carbon nanotubes on the conductor (electrode).

In addition to the wavelength and intensity of the excitation light, the potential energy and life duration of the excited electron in the carbon nanotube, the reduction potential and the activation energy for reaction of the metal ion, and the reaction rate for charge compensation by the electron donor affect the reaction rate for deposition of the metal species and the selectivity of the concentrated carbon nanotube.

Moreover, a potential is applied to the conductor on which to immobilize the carbon nanotubes, allowing electrochemical control of the electronic energy in the conductor to change a force for driving the aforementioned photo-induced charge transfer reaction and to add a factor for selecting the carbon nanotube.

Accordingly, photo-irradiation for inducing the photoreaction should be simultaneously conducted with application of a potential on the conductor.

The metal species reduced and deposited on the carbon nanotube deposited and fixed on the conductor may be easily removed by acid treatment or the like.

(Description of preferred embodiments)

Hereinafter, the preferred embodiments of the present invention will be described. The embodiments described below are intended to facilitate the better appreciation of the present invention, and the scope of the present invention is not limited to the description below. Accordingly, it is apparent that those skilled in the art may alter within the scope of the present invention considering the description in the specification if appropriate.

In one aspect, the present invention provides a method for manufacturing a composition of carbon nanotubes having a single or a few types of desired chiralities, which comprises the steps of: (a) preparing a solution containing carbon nanotubes; and (b) irradiating the solution with a laser beam. Herein, the carbon nanotube composition comprises the carbon nanotubes having a single chiral vector (n, m) at a purity of more than 50% based on the unit of number, preferably 90% or more, more preferably 95% or more, further more preferably 99% or more, and most preferably 100%, wherein n and m are integers. This method allows provision of a carbon nanotube composition having a desired chiral vector (n, m) at a high purity from among the carbon nanotubes having various chiralities.

In another aspect, the present invention provides a method for manufacturing an array of a carbon nanotube composition, which comprises the steps of: (a) preparing a solution containing carbon nanotubes; and (b) irradiating the solution with a laser beam. Herein, the carbon nanotube composition comprises carbon nanotubes having a single chiral vector (n, m) at a purity of more than 50% based on the unit of number, preferably more than 90%, more preferably more than 95%, further more preferably 99%, and most preferably 100%, wherein n and m are integers. This method allows high selective deposition/immobilization of a single-walled nanotube (SWNT) having a desired chiral vector (n, m) on a solid substrate from among the carbon nanotubes having various chiralities, thereby to provide an array for electronic devices.

In one embodiment, the carbon nanotubes in a step a) in the aforementioned two aspects have a plurality of different chiralities.

The carbon nanotube having a single chiral vector, which composes a carbon nanotube composition of the present invention, is preferably single-walled carbon nanotube.

In one embodiment, the method of the present invention uses an aqueous dispersion solution or an aqueous solution of carbon nanotubes containing a metal ion and an electron donor as a solution containing carbon nanotubes. The metal ion used in the present invention is preferably the ion species of a transition metal element selected from a group consisting of alkali metal elements, alkali earth metal elements, IIIA to VIIA group elements, VIII group elements, and IB group elements, or any of rare earth elements. The electron donor used in the present invention is preferably selected from a group consisting of alcohols, amines, arginine, benzaldehyde, hydrazine, carboxylic acids, amino acid, toluene, alkyl benzenes, terpenes, ethers, silanes, and thiols, and is more preferably alcohols, and most preferably methanol.

In preferred embodiments, the laser beam in the aforementioned two aspects is a laser beam corresponding to interband transition energy of a desired carbon nanotube. This allows selective reaction of the SWNT having a band gap corresponding to the photon energy of the laser beam with the metal ion in the solution, thereby to immobilize selectively the SWNT having a single type or a few types of chiralities from among the carbon nanotubes having a plurality of chiralities simultaneously excited by monochromatic light depending on the reduction potential and activation energy of the metal ion to be reacted with. The white light source can be used instead of laser beam to immobilize simultaneously a plurality of SWNTs having various band gaps.

In a more preferred embodiment, the step b) in aforementioned two aspects is carried out in the presence of a magnetic field. This allows high selective deposition/immobilization of SWNTs having a single diameter in addition to a single chirality on the solid substrate.

The application of a magnetic field is carried out, for example, by placing a magnet immediately under a light-irradiated spot on the solid substrate.

The metal species reduced and deposited on the carbon nanotube deposited/fixed on the solid substrate may be easily removed by acidic treatment or the like.

One specific, preferred procedure of the present invention for selectively fixing carbon nanotubes on the substrate is described below:

I) Holding a solution containing a carbon nanotube on a substrate, wherein the carbon nanotube is dispersed in a solvent by a dispersant such as SDS;
II) Adding a sacrificial electron donor such as methanol together with an electron acceptor such as a metal ion in the solution of above-mentioned I);
III) And then, irradiating a target point with laser beam corresponding to interband transition energy of the carbon nanotube.
By following steps I) to III), the metal ion is reduced and deposited on the carbon nanotube, and the carbon nanotube is selectively fixed at the photo-irradiated point on the substrate. The whole procedure for immobilization may be easily performed under observation with a microscope. The magnetic metal can be deposited to facilitate the immobilization of the carbon nanotube by placing a magnet immediately under the substrate. The area in which to immobilize the carbon nanotube is controlled by adjusting the cross-sectional size of irradiated light. The fixed carbon nanotube may be qualified and quantified using laser-induced resonant Raman scattering measurement.

The method of the present invention provides a carbon nanotube composition having various physical properties described below.

One embodiment provides a carbon nanotube composition having an absolute value for n of smaller than 100 and an absolute value for m of three or larger and smaller than 100.

Another embodiment provides a carbon nanotube composition wherein n and m are different, m is not 0 (zero), and the composition has a clockwise helical structure.

Further another preferred embodiment provides a carbon nanotube composition wherein n and m are different, m is not 0 (zero), and the composition has a counter-clockwise helical structure.

The other embodiment provides a carbon nanotube composition wherein the composition has a half bandwidth of smaller than 8 cm$^{-1}$ for the spectrum corresponding to the radial breathing mode (RBM) observed in a wave number region of 100 to 600 cm$^{-1}$ in laser-induced Raman scattering measurement.

Further other embodiment provides a carbon nanotube composition wherein the composition is controlled to have a structural defect density of $10^{-6}$ to $10^{-1}$ per 1 $\mu$m of the tube in terms of a carbon element ratio caused by carbon lattice defect or impurities. This allows the carbon nanotube composition to exhibit the superior performance for an array for electronic devices.

An additional embodiment provides a carbon nanotube composition wherein the composition is controlled to have a positive or negative charge density of $10^{-5}$/carbon atom or less and has an excessive charge carrier given by neutral and charge doping.

One preferred embodiment provides carbon nanotubes, which compose the carbon nanotube composition of the present invention and have a single diameter of 0.3 nm to 10 nm.

Another preferred embodiment provides a carbon nanotube composition of the present invention, which exists in a haploid of carbon nanotubes having a single chirality.

Further another preferred embodiment provides a carbon nanotube composition of the present invention, which exists in a bulk or an aggregate of carbon nanotubes having a single chirality.

The present invention also provides a carbon nanotube composition, which has a combination of as many aforementioned physical properties as possible.

Moreover, the method of the present invention can manufacture an array of carbon nanotube compositions, wherein the carbon nanotube compositions are highly selectively fixed on the solid substrate.

(Electronic devices using the array of a single carbon nanotube)

The present invention can position-selectively immobilize a determined number of single carbon nanotubes having a certain chirality on the substrate, and thus the following applications may be achieved.

1) A single carbon nanotube having a certain chirality is locally fixed between two micro electrodes formed on the substrate to compose a current detection type chemical-bio substance sensor having the certain chirality.

2) Single-walled nanotube (SWNT) is fixed between two electrodes formed on a transparent substrate to compose a photo detector/photodiode wherein the carbon nanotube generates a photoelectromotive force and conducts light to control its photo-responsive property through a certain chirality.

3) A SWNT having a certain chirality is formed on a $SiO_2$/Si substrate and patterned to compose an electronic circuit including a field-effect transistor (FET), wherein the circuit uses the SWNT having more uniform current-potential characteristics.

4) A single carbon nanotubes having a certain chirality is fixed between two micro electrodes to compose a single electronic device, which has characteristics further controlled based on quantized conductance behavior.

5) A carbon nanotube is formed on a conductive film and then patterned to compose a flexible plastic electronic device.

6) Carbon nanotubes are continuously fixed on the flow path of a micro channel formed on a glass substrate to compose a micro filter using the molecule-adsorptive capability of the carbon nanotube.

7) A carbon nanotube is position-selectively fixed on a small substrate having electrical contacts to compose a carbon nanotube micro electrode.

8) A carbon nanotube having a certain chirality is structure-selectively fixed on a micro pattern electrode at a high density and orientation to provide a material for a next-generation field emission display.

9) A plurality of carbon nanotubes is used to construct a steric configuration on a conductive substrate, followed by contacting the probe (chip) of a scanning tunnel microscope (STM) to construct a nano conductive channel toward a vertical direction to the substrate.

10) A carbon nanotube having a certain diameter is fixed on a substrate to compose a standard scale for nano meter-level of measurement including a scanning probe microscopy.

The references such as scientific literatures, patent documents, patent applications referred to in the specification are cited herein to the same extent that their contents are specifically described.

For easy comprehension, referring to the preferred embodiments, the present invention has been described. Hereinafter, the present invention will be described based on the examples. The aforementioned description and the following description are intended only for exemplification, but not intended to limit the present invention. For this reason, the scope of the present invention is not limited to either the embodiments or examples specifically described in the specification, but limited only by accompanying claims.

[Examples]

Hereinafter, the present invention will be specifically described referring to the examples but not limited to these examples.

(Example 1: Immobilization of SWNTs and Raman analysis)

The commercially available SWNT produced by the HiPco method, which is one kind of CVD methods, was mixed with 1 wt% of dodecylsodium sulfate (SDS) solution, irradiated with ultrasonic wave in an ultrasonic bath for one hour, and then centrifuged at 14, 000 rpm for one hour to separate a supernatant fluid, that is, a SWNT/SDS dispersion. 200 $\mu$L of the SWNT/SDS dispersion (SWNT: about 10 $\mu$g/mL) was mixed with methanol to have a methanol concentration of 2 M and spotted at two positions separately on a glass substrate. One spot was supplied with an aqueous ferrous sulfate ammonium sulfuric acid solution to get a pH of about 3 and a Fe (II) ion concentration of 10 mM. The other spot is supplied with an aqueous manganese chloride solution to get a pH of about 6 and a Mn (II) ion concentration of 10 mM. Next, both the spots were irradiated with laser beam having a wavelength of 785 nm which was converged by an optical lens to have a diameter of about 1 $\mu$m.

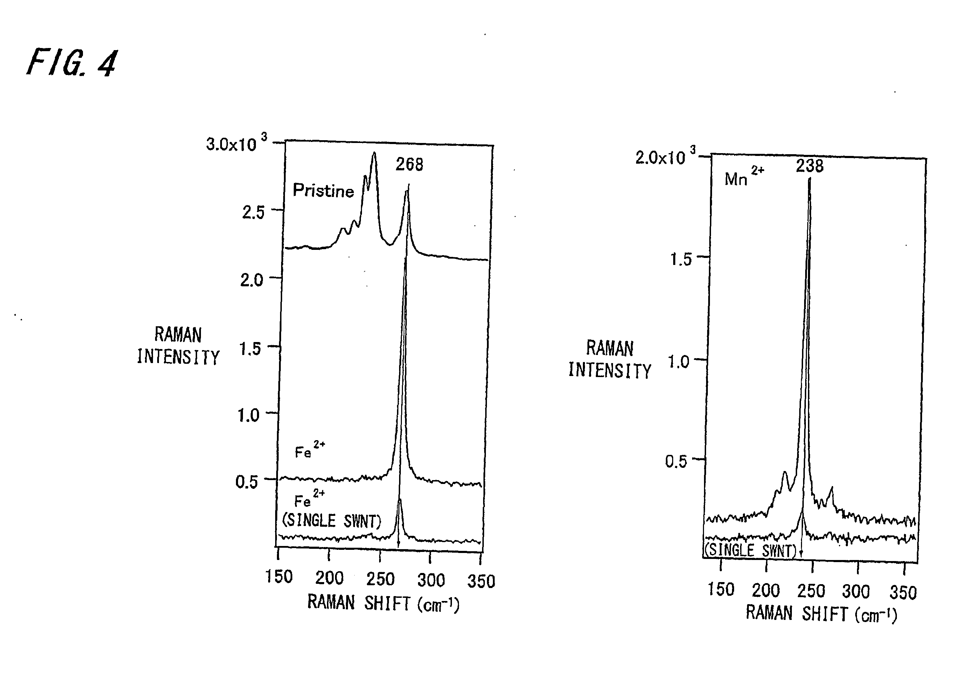

The resonant Raman spectrum of the SWNT in the radial breathing mode region is shown in FIG.4, wherein the SWNT was irradiated with laser beam having a wavelength of 785 nm in the presence of Fe (II) ion and Mn (II) ion to immobilize.

As known from FIG.4, from among SWNT samples having a wide diameter distribution of about 0.8 to 2 nm, the SWNT having a peak at 268 $cm^{-1}$ was selectively fixed in the presence of the Fe (II) ion. This can be assigned to a semiconductive tube having a chiral vector of (11,0) and a diameter of 0.87 nm.

On the other hand, the SWNT having a peak at 238 $cm^{-1}$ was selectively fixed in the presence of the Mn (II) ion. This can be assigned to a semiconductive tube having a diameter of 1.00 nm and a chiral vector of (12,1).

Both of them had a half bandwidth of about 6 $cm^{-1}$ which was identical to that of a single SWNT, indicating that a large number of SWNTs maintaining a single chirality were fixed. This was resulted under a condition that a glass substrate was used and a magnet was placed immediately under a light-irradiated spot. But no applied magnetic field fixed SWNTs having various diameter distributions.

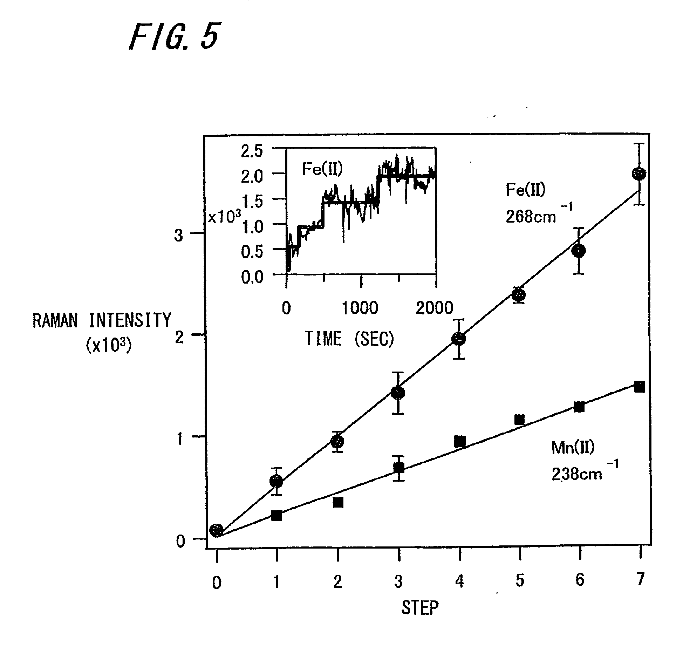

A change in Raman scattering intensity observed at 268 $cm^{-1}$ and 238 $cm^{-1}$ when one spot was continuously irradiated with laser beam having a wavelength of 785 nm in the presence of Fe (II) / Mn (II) ion is shown in FIG. 5. Besides, a diagram showing a change observed in the presence of the Fe (II) ion is inserted in FIG. 5. As shown in the insertion, the Raman intensity varied stepwise with light irradiation time, each step being associated with an increase of fixed SWNTs in quantity. The Raman intensity shown in FIG. 5 is proportional to the number of steps, indicating that the SWNTs were irradiated with continuous laser beam to be fixed stepwise individually.

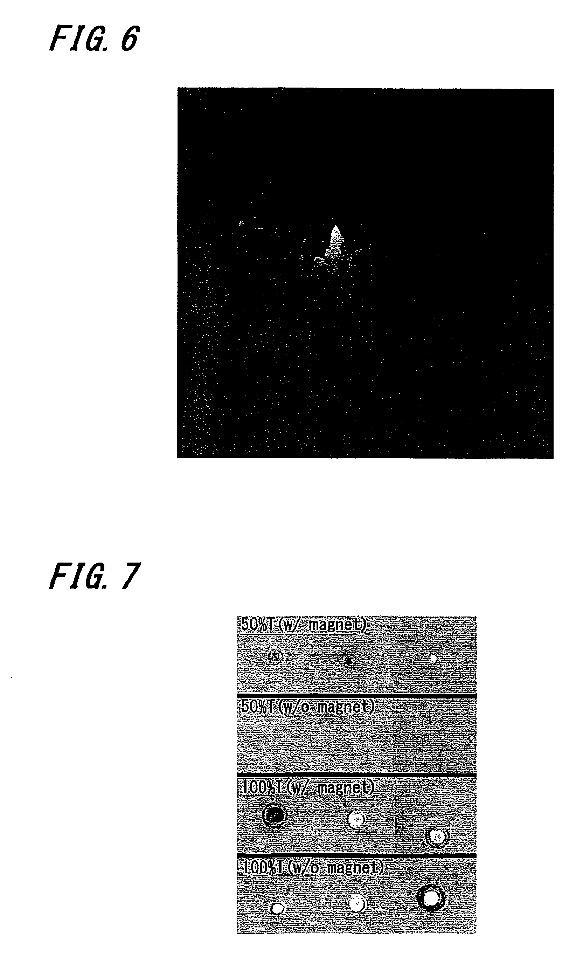

Moreover, an AFM image around the spot irradiated with laser beam in the presence of the Fe (II) ions is shown in FIG. 6. FIG. 6 shows an image that SWNTs were position-selectively fixed.

(Example 2: Control of amount of fixed SWNTs)

The commercially available SWNTs produced by the HiPco method, which is one kind of CVD methods, were mixed with 1 wt% of dodecylsodium sulfate (SDS) solution, irradiated with ultrasonic wave in an ultrasonic bath for one hour, and then centrifuged at 14,000 rpm for one hour to separate a supernatant fluid, that is, an SWNT/SDS dispersion. 200 $\mu$L of the SWNT/SDS dispersion (SWNT: about 10 $\mu$g/mL) was mixed with methanol to have a methanol concentration of 2 M and kept on a glass substrate. This resultant was supplied with an aqueous ferrous sulfate ammonium sulfuric acid solution to get a pH of about 3 and a Fe (II) ion concentration of 10 mM, and then irradiated with laser beam having a wavelength of 785 nm which was converged by an optical lens to have a diameter of about 1 $\mu$m. A rare earth permanent magnet (magnetic flux density: about 60 mT) was placed immediately under the substrate at photo irradiated spot to apply a magnetic field.

Then, the effects of the light and the magnetic field in the presence of the Fe (II) ion were observed from a CCD image under the light-irradiated spot. The observed CCD image is shown in FIG. 7.

In FIG, 7, the light irradiation time increases toward the right side under an individual condition. SWNTs were non-selectively fixed at a high light intensity (100%T, about 2 mW) no matter whether a magnetic field is applied or not. On the contrary, it is demonstrated that at a light intensity reduced to 50%, no SWNT was confirmed to be fixed with no magnetic field applied, and at a lower photon density, SWNTs were selectively fixed with a magnetic field applied. The metal species deposited simultaneously were dissolved to remove by acidic treatment, thereby to provide the pure SWNTs.

It was clarified that SWNTs and metal ions in concentration as well as laser-beam in irradiation intensity and time could be adjusted in this way to control the amount of SWNTs fixed on the substrate.

(Example 3: Fabrication of SWNT array)

The position of light-irradiated spot can be controlled to fabricate and pattern a SWNT array.

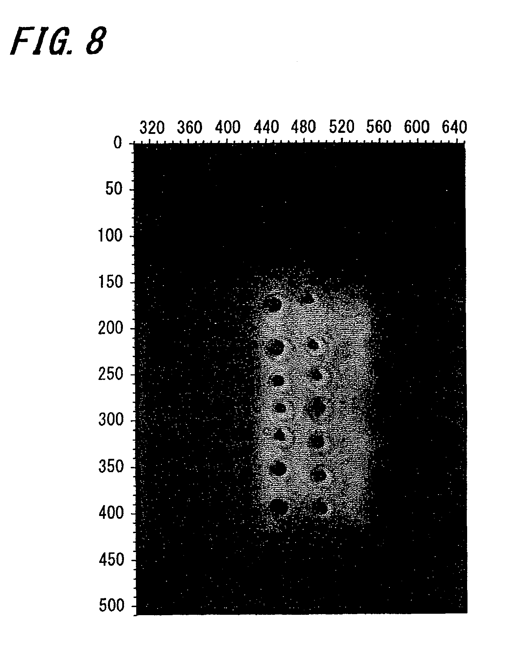

The optical microscopic image of a SWNT microdot array formed on a glass substrate with laser beam having a wavelength of 785 nm which was converged to have a diameter of about 1 $\mu$m is shown in FIG. 8.

As known from FIG. 8, the positions at which to immobilize SWNTs could be controlled in a micrometer order (in the same condition of 100%T with a magnetic field applied as in FIG. 7).

The excitation light was scanned on the substrate to immobilize continuously and optically pattern the SWNTs. Moreover, the wavelength of the excitation light could be changed to form films for conjugating the SWNTs having different band gaps could be formed.

(Example 4: Immobilization of SWNTs on a substrate)

The commercially available SWNTs produced by the HiPco method, which is one kind of CVD methods, were added into a 1 wt% of dodecylsodium sulfate (SDS) solution, irradiated with ultrasonic wave in an ultrasonic bath for one hour. The resultant was centrifuged at 14,000 rpm for one hour to separate a supernatant fluid, and this procedure was repeated to get an SWNT/SDS dispersion(SWNT content: to about 10 μg/mL).

100 μL of the SWNT/SDS dispersion was diluted with 100μL of superpure water (Milli-Q water), and supplied with methanol to have a methanol concentration of 2 M, and then supplied with an aqueous ferrous sulfate ammonium acidic solution (10 mM) to prepare a sample solution.

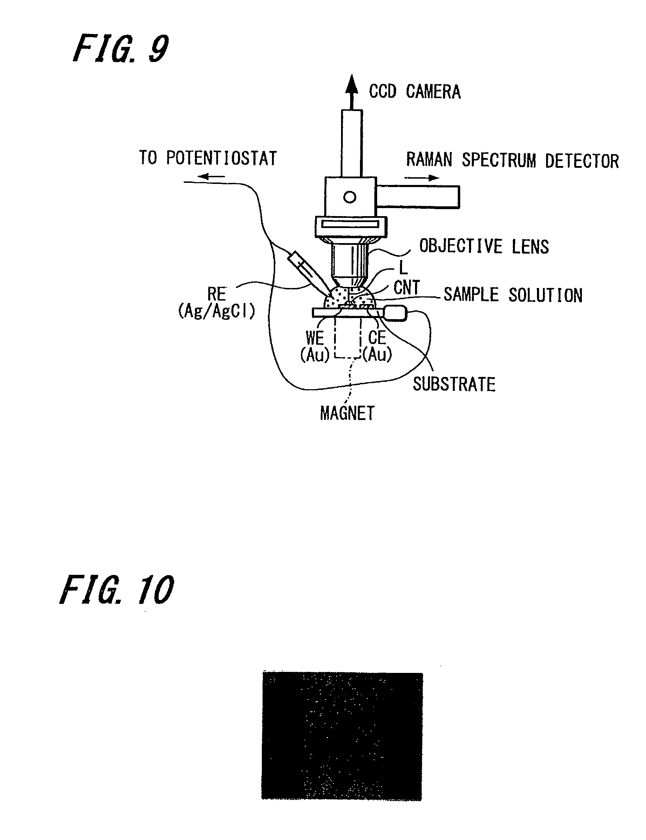

A potential-controlled SWNT photo deposition apparatus shown in FIG. 9 was built and used to carry out a step of irradiating light.

The potential-controlled SWNT photo deposition apparatus shown in FIG. 9 comprises a substrate on which to spot a sample solution, and an optical system for irradiating the sample solution with light and detecting Raman scattering light.

On the surface of the substrate, there are formed a working electrode WE and a counter electrode CE, both of which are made of gold (Au) electrode plates. To control their potentials, there is formed a reference electrode RE composed of an Ag/AgCl electrode, and these working electrodes WE, counter electrodes CE, and reference electrodes RE, are connected to a potentiostat (not shown). The potentiostat controls the working electrode WE to have a desired potential in relation with the reference electrode RE. Specifically, it controls the current between the working and counter electrodes in response to the reaction occurring at the working electrode WE.

The optical system comprises a laser beam source (not shown) and an objective lens (of 100 magnification), and an internal lens to serve as an optical microscope. The objective lens converges laser beam L to irradiate a sample solution, and magnifies an image on the surface of the working electrode WE.

Above the optical system, a CCD camera (not shown) such as a video camera is connected to allow detecting a irradiation position of the laser beam L and photographing an image of the surface on the working electrode WE.

On the right side of the optical system, a Raman spectrum detector (not shown) is connected to detect a scattering Raman light.

Besides the laser beam L for photoreaction of carbon nanotubes, there is disposed a light source (for laser or the like) for irradiating light to obtain scattering Raman light (not shown).

As shown by a chain line in FIG. 9, a permanent magnet is placed under the substrate to apply the working electrode WE and the sample solution thereon with a magnetic field.

On the substrate in the potential-controlled SWNT photo deposition apparatus shown in FIG. 9, the sample solution prepared in the aforementioned manner was spotted to cover the working electrode WE and the counter electrode CE, and inserted with the reference electrode RE.

Then, the spots of the sample solution were irradiated with a laser beam L of 785 nm through the objective lens. This light irradiation concentrated SWNTs as carbon nanotubes CNT on the gold working electrode WE.

The optical microscopic image of SWNTs concentrated on the gold electrode is shown in FIG. 10. In the figure, the width of the gold electrode is 10 μm.

Next, the amount of concentrated SWNTs was evaluated by detecting the Raman scattering spectrum under a microscope and determining the photoelectric current.

The photoelectric current was determined by modulating the light source by an optical chopper, and amplifying a current signal from the potentiostat synchronizing with the modulation of the light source by means of a lock-in amplifier.

(Experiment 1)

First, the permanent magnet was placed under the substrate, and the gold working electrode WE was kept to have a potential of +0.1 V (against the Ag/AgCl reference electrode RE), and then the sample solution prepared by the aforementioned procedure was irradiated with 2.6 mW of laser beam L having a wavelength of 785 nm to conduct the step of photo irradiation.

Next, the Raman scattering peak intensity at a wave number of 234 $cm^{-1}$ and the photoelectric current were measured to determine their changes in relation to the light irradiation time. The effective intensity of Raman excitation was 1mW and exposure time was five seconds.

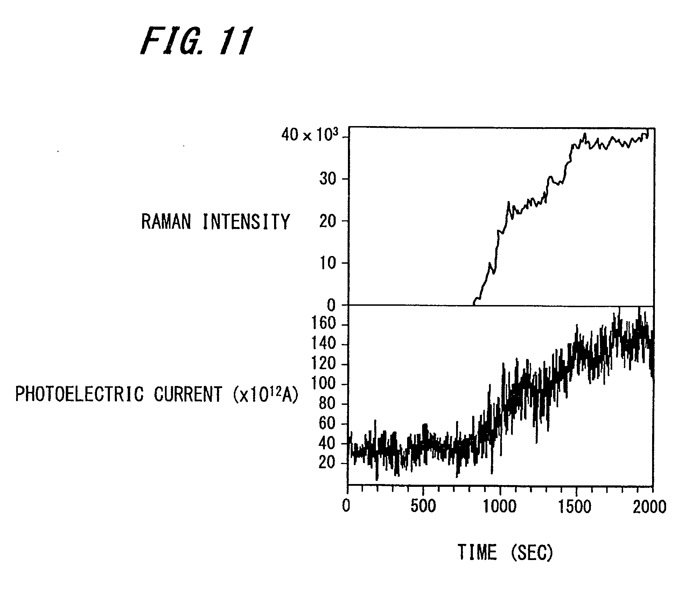

The measurement result is shown in FIG. 11.

As shown in FIG. 11, both the Raman scattering intensity and photoelectric current value increased with time, indicating that on the gold electrode were being fixed SWNTs which had a certain diameter and a Raman scattering peak appearing at a wave number of 234 $cm^{-1}$.

(Experiment 2)

Next, the gold electrodes as working electrodes WE were kept to have their respective potentials of -0.5 V, 0.0 V, and +0.5 V (against the Ag/AgCl reference electrode RE) with no magnet disposed under a substrate to carry out light irradiation procedure in the same manner as in Experiment 1.

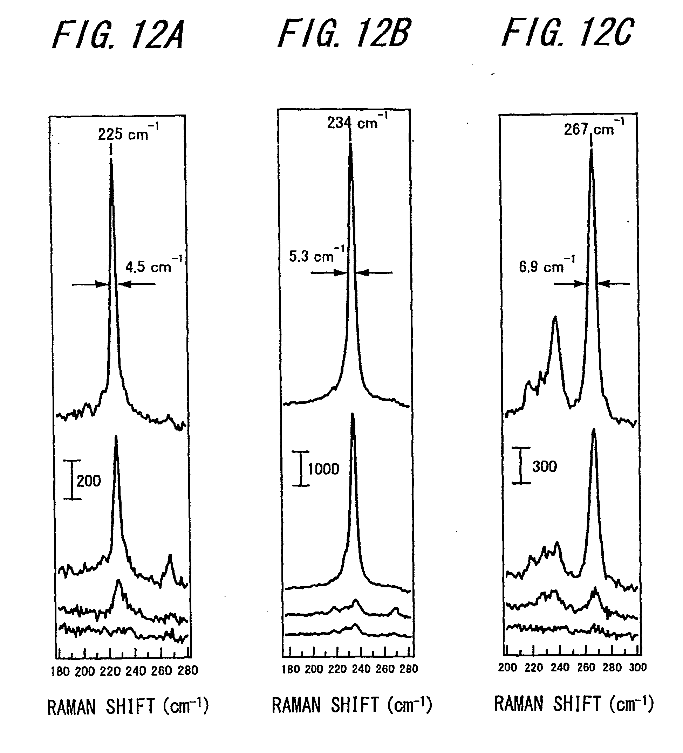

Then, caused by irradiation of an optical intensity of 0.7 mW and an exposure time of five seconds, changes in Raman scattering spectrum were measured in relation to light irradiation time. The measurement result is shown in FIGS. 12A to 12C. In FIG. 12A, the result with the gold electrode set to have a potential of -0.5 V, is shown, in FIG.12B, the result with the gold electrode set to have a potential of 0.0 V, is shown, and in FIG.12C, the result with the gold electrode set to have a potential of +0.5 V, is shown.

In FIGS, 12A and 12B, changes in the Raman scattering spectra are shown with various irradiation time within a wave number range of 180 cm$^{-1}$ to 280 cm$^{-1}$. In FIG. 12C, changes in the Raman scattering spectra are shown with various irradiation time within a wave number range of 200 cm$^{-1}$ to 300 cm$^{-1}$.

As known from FIG. 12A, when the gold electrode had a potential of -0.5 A, the peak at 225 cm$^{-1}$ selectively increased in the spectrum. With the longest irradiation time, the peak had a full width at half maximum, fwhm, of 4.5 cm$^{-1}$.

As known from FIG. 12B, when the gold electrode had a potential of 0.0 A, the peak at 234 cm$^{-1}$ selectively increased in the spectrum. With the longest irradiation time, the peak had a full width at half maximum, fwhm, of 5.3 cm$^{-1}$.

As known from FIG.12C, when the gold electrode had a potential of +0.5 V, the peak at 267 cm$^{-1}$ selectively increased in the spectrum.

With the longest irradiation time, the peak had a full width at half maximum, fwhm, of 6.9 cm$^{-1}$.

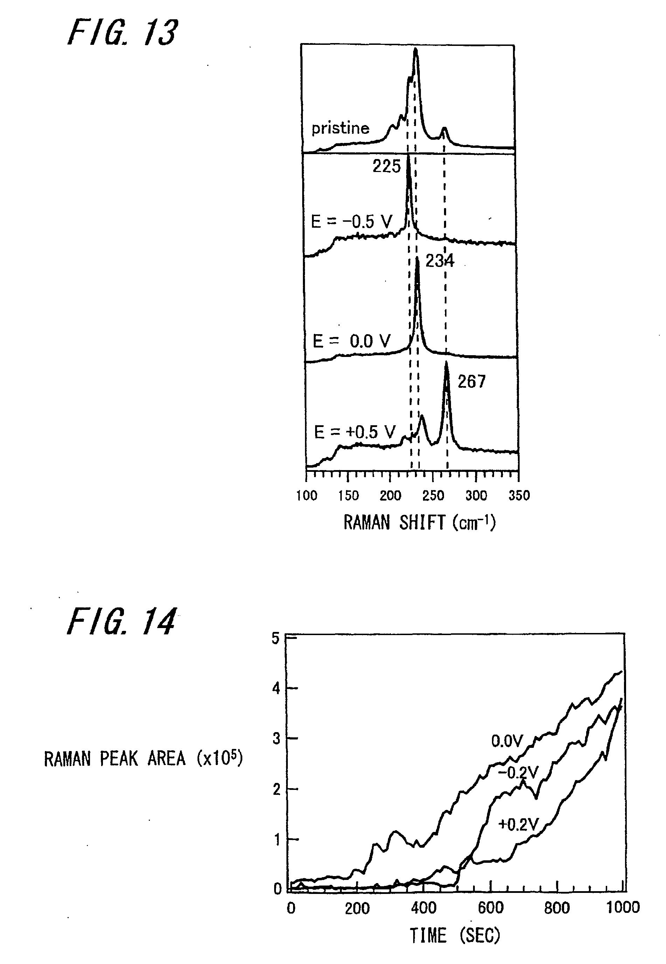

Comparison between the Raman scattering spectrum observed in Experiment 2 and the scattering spectrum of the unseparated sample (pristine) as the control, is shown in FIG. 13. The sample before separation was prepared on the gold substrate in air at a Raman excitation light intensity of 1.3 mW.

As known from FIG. 13, depending on the potential applied on the working electrode WE, SWNTs having their respective different peak positions, namely having their respective various diameters were selectively concentrated. The sample before separation was found to contain three peaks, which were then selectively extracted.

(Experiment 3)

Next, a permanent magnet was placed under the substrate, and the gold electrodes of the working electrodes WE were kept to have their respective potentials of -0.2 V, 0.0 V, and + 0.2 V (against the Ag/AgCl reference electrode), to carry out the step of light irradiation at a Raman excitation light intensity of 0.5 mW in the same manner as in Experiment 1, and to determine changes in Raman scattering intensity in relation to light irradiation time. The measurement result is shown in FIG. 14.

As known from FIG. 14, Raman intensity increased with the time in any of electrode potentials, indicating that the SWNTs were progressively being concentrated.

(Experiment 4)

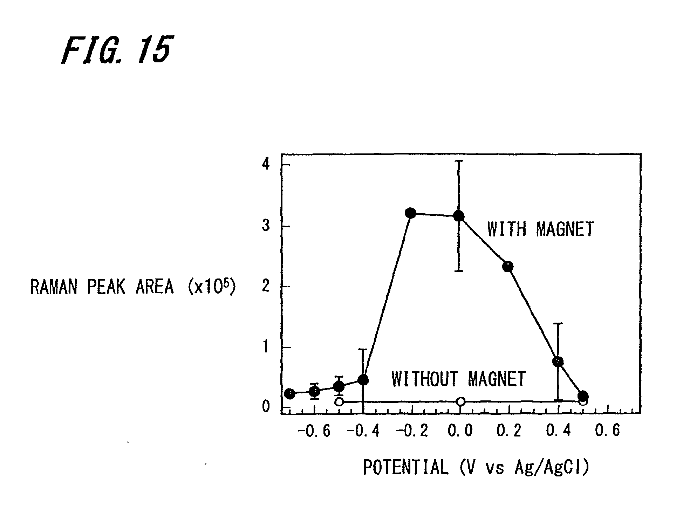

The samples were prepared with or without a magnet disposed by various the potential of the gold electrode of the working electrode WE and irradiating at a Raman excitation light intensity of 0.5 mM for an exposure time of five seconds. Some of samples were prepared in the same manner as in Experiment 3. The samples were subjected to light irradiation for 15 minutes, and then their Raman scattering intensities were measured. The measurement result is shown in FIG. 15 by plotting the change in measured Raman scattering intensity versus the potential of the electrode. A symbol "●" indicates the case with a magnet, while "o" indicates the case without a magnet.

As known from FIG. 15, with a magnet disposed, the less negative potential the electrode was selected to have, the higher the Raman intensity became, and the Raman intensity reaches its maximum at -0.2 V. In addition, a magnet was used to increase the Raman intensity, indicating that the magnet facilitated the concentration of SWNTs.

The present invention is not limited to the aforementioned embodiments and examples, and may take any other various modifications within the spirit of the present invention.

The present invention can immobilize a certain number of single carbon nanotubes having a certain chirality position-selectively on a substrate. Therefore, the present invention provides electric circuits, single electronic devices, flexible plastic electronic devices, and micro filters, including current detectors/bio material sensors, photo detectors, photo diodes, and field effect transistors (FET), and standard scales for measuring at a nanometer level, including carbon nanotube microelectrodes, next-generation materials for electric field discharge displays, nano conductive channels, and scanning probe microscopes.

**Claims**

1.  A carbon nanotube composition comprising carbon nanotubes having a single chiral vector (n, m) at a purity of more than 50% based on the unit of number, wherein n and m are integers.

2.  The carbon nanotube composition as defined in Claim 1, comprising said carbon nanotubes at a purity of 90% or more based on the unit of number.

3.  The carbon nanotube composition as defined in Claim 1, wherein the absolute value for n is smaller than 100 and the absolute value for m is three or more and less than 100.

4.  The carbon nanotube composition as defined in Claim 1, wherein n and m are different, m is not 0 (zero), and the tubes have a clockwise helix structure.

5.  The carbon nanotube composition as defined in Claim 1, wherein n and m are different, m is not 0 (zero), and the tubes have a counter-clockwise helix structure.

**6.** The carbon nanotube composition as defined in Claim 1, wherein the spectrum corresponding to a Radial Breathing Mode (RBM) observed within a wavenumber region of 100 to 600 $cm^{-1}$ has a half bandwidth of less than 8 $cm^{-1}$ in laser-induced resonance Raman scattering measurement.

**7.** The carbon nanotube composition as defined in Claim 1, wherein said tubes have a single diameter.

**8.** The carbon nanotube composition as defined in Claim 7, wherein said diameter is 0.3 to 10 nm.

**9.** The carbon nanotube composition as defined in Claim 1 or 7, wherein the composition exists as a haploid of said carbon nanotubes.

**10.** An array of the carbon nanotube composition as defined in Claim 1 or 9, wherein the array is fixed on a solid substrate.

**11.** The array of the carbon nanotube composition as defined in Claim 10, wherein said solid substrate is an insulating substrate, a semiconductor substrate, or a metallic substrate.

**12.** An electronic device comprising the array as defined in Claim 10.

**13.** A method for manufacturing a carbon nanotube composition composed of tubes having a desired single chirality, comprising the steps of:

(a) preparing a solution containing carbon nanotubes; and
(b) irradiating said solution with a laser beam, wherein

said carbon nanotube composition comprises carbon nanotubes having a single chiral vector (n, m) at a purity of more than 50% based on the unit of number, where n and m are integers.

**14.** The method for manufacturing a carbon nanotube composition as defined in Claim 13, wherein said carbon nanotube composition comprises carbon nanotubes having a single chiral vector (n, m) at a purity of 90% or more based on the unit of number.

**15.** The method for manufacturing a carbon nanotube composition as defined in Claim 13, wherein the carbon nanotubes in said step (a) have a plurality of different chiralities.

**16.** The method for manufacturing a carbon nanotube composition as defined in Claim 13, wherein said solution is an aqueous dispersion or an aqueous solution of the carbon nanotubes, which contains a metal ion and an electron donor.

**17.** The method for manufacturing a carbon nanotube composition as defined in Claim 13, wherein said laser beam is a laser beam corresponding to a transition energy between bands of desired carbon nanotubes.

**18.** The method for manufacturing a carbon nanotube composition as defined in Claim 16, wherein said step (b) is conducted in the presence of a magnetic field using magnetized metal ions as said metal ions.

**19.** The method for manufacturing a carbon nanotube composition as defined in Claim 13, further comprising the step of (c) separating and purifying the carbon nanotube composition deposited by said step (b).

**20.** The method for manufacturing a carbon nanotube composition as defined in Claim 13, wherein said solution with the substrate immersed therein is irradiated with the laser beam in said step (b).

**21.** The method for manufacturing a carbon nanotube composition as defined in Claim 13, further comprising the step of supplying the substrate using a conductor with said solution and applying said conductor with a given potential in said step (b).

**22.** The method for manufacturing a carbon nanotube composition as defined in Claim 21, wherein said conductor is applied with a given potential to have a controlled surface potential of -13.0 V to +2.0 V against that of a standard hydrogen electrode.

**23.** The method for manufacturing a carbon nanotube composition as defined in Claim 13, wherein any conductive material selected from a noble metal, a base metal, indium tin oxide, glassy carbon, Highly Oriented Pyrolytic Graphite (HOPG), and silicon, is used for said substrate.

**24.** The method for manufacturing a carbon nanotube composition as defined in Claim 16, wherein said metal ion is the ion species of a transition metal element selected from the group consisting of alkali metal elements, alkali earth metal elements, IIIA to VIIA group elements, VIII group elements, and IB group elements, or of a rare earth element.

**25.** The method for manufacturing a carbon nanotube composition as defined in Claim 16, wherein said electron donor is a material selected from the group consisting of alcohols, amines, arginine, benzaldehyde, hydrazine, carboxylates, amino acids, toluene, alkyl benzens, terpenes, ethers, silanes, and thiols.

**26.** A carbon nanotube composition manufactured by the method as defined in Claim 13.

27. An array formed by the method as defined in Claim 20, wherein a carbon nanotube composition is fixed on a solid substrate.

# FIG. 1

Chiral vector : $C_h = na + mb$

when
$\begin{cases} (n-m) = 3q & \text{metallic SWNT} \\ (n-m) \neq 3q & \text{semiconducting SWNT} \end{cases}$
(where q is integer)

○ metallic
● semiconducting

$\theta$

$A(n, m)$

$O(0, 0)$

$C_h$

n

m

a

b

## FIG. 2

Fe  e⁻
Fe²⁺

hν  $E_{ii}$

ELECTRON DONOR (e·g· METHANOL)

e⁻

## FIG. 3

RAMAN SPECTRUM DETECTOR

OBJECTIVE LENS
LUMPLANFL 100×,
NA= 1.00, OLYMPUS

SWNT/SDS DISPERSION SOLUTION · · · 200 μl
ELECTRON DONOR (METHANOL)     · · · 25 μl
0.1 M METALLIC ION SOLUTION · · · 100 μl

$Fe(NH_4)_2(SO_4)_2$, $MnCl_2$, $CoCl_2$
$NiCl_2$, $AgNO_3$, $CuSO_4$

SLIDE GLASS

MAGNET

SWNT RAMAN SPECTRUM

RAMAN INTENSITY
(a.u)

RBM

G-BAND

D-BAND

G'-BAND

1000    2000    3000

RAMAN SHIFT (cm⁻¹)

# FIG. 4

## FIG. 5

## FIG. 6

## FIG. 7

FIG. 8

## FIG. 9

CCD CAMERA

TO POTENTIOSTAT

RAMAN SPECTRUM DETECTOR

OBJECTIVE LENS

L

RE
(Ag/AgCl)

CNT

SAMPLE SOLUTION

WE
(Au)

CE
(Au)

SUBSTRATE

MAGNET

## FIG. 10

# FIG. 11

RAMAN INTENSITY

PHOTOELECTRIC CURRENT (x10$^{12}$A)

TIME (SEC)

# FIG. 12A

225 cm$^{-1}$

4.5 cm$^{-1}$

$\updownarrow$200

180 200 220 240 260 280

RAMAN SHIFT (cm$^{-1}$)

# FIG. 12B

234 cm$^{-1}$

5.3 cm$^{-1}$

$\updownarrow$1000

180 200 220 240 260 280

RAMAN SHIFT (cm$^{-1}$)

# FIG. 12C

267 cm$^{-1}$

6.9 cm$^{-1}$

$\updownarrow$300

200 220 240 260 280 300

RAMAN SHIFT (cm$^{-1}$)

## FIG. 13

RAMAN SHIFT (cm⁻¹)

## FIG. 14

RAMAN PEAK AREA (x10⁵)

TIME (SEC)

FIG. 15

RAMAN PEAK AREA $(\times 10^5)$

WITH MAGNET

WITHOUT MAGNET

POTENTIAL (V vs Ag/AgCl)

## INTERNATIONAL SEARCH REPORT

| International application No. |
| --- |
| PCT/JP2006/309558 |

A. CLASSIFICATION OF SUBJECT MATTER
*C01B31/02*(2006.01), *B82B1/00*(2006.01)

According to International Patent Classification (IPC) or to both national classification and IPC

B. FIELDS SEARCHED

Minimum documentation searched (classification system followed by classification symbols)
*C01B31/02*(2006.01), *B82B1/00*(2006.01)

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)
CAplus(STN), JSTPlus(JDream2), WPI, Science Direct

C. DOCUMENTS CONSIDERED TO BE RELEVANT

| Category* | Citation of document, with indication, where appropriate, of the relevant passages | Relevant to claim No. |
| --- | --- | --- |
| X<br>A | US 2004/0040834 A1 (Richard E. SMALLEY),<br>04 March, 2004 (04.03.04),<br>Claims 1 to 76<br>& JP 2005-527455 A    & WO 2003/084869 A2 | 1-12,26,27<br>13-25 |
| X<br>A | WO 2004/048256 A2 (E.I. DU PONT DE NEMOURS AND CO.),<br>10 June, 2004 (10.06.04),<br>Claims 1 to 19; page 1, line 5 to page 2, line 20<br>& JP 2006-512276 A | 1-12,26,27<br>13-25 |
| A | JP 2003-128406 A (The Mitre Corp.),<br>08 May, 2003 (08.05.03),<br>& US 2003/0031619 A1    & EP 1284236 A1 | 1-27 |

☒ Further documents are listed in the continuation of Box C.  ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| | |
| --- | --- |
| Date of the actual completion of the international search<br>23 June, 2006 (23.06.06) | Date of mailing of the international search report<br>04 July, 2006 (04.07.06) |
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

International application No.

PCT/JP2006/309558

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2003-95626 A  (NEC Corp.),<br>03 April, 2003 (03.04.03),<br>(Family: none) | 1-27 |
| A | V.A. KARACHEVTSEV et al., Raman spectroscopy<br>of HiPCO single-walled carbon nanotubes at<br>300 and 5 K, Carbon, 2003, Vol.41, pages 1567<br>to 1574 | 1-27 |
| A | Ken'ichi OKAZAKI et al., "Koritsu Tanso Carbon<br>Nano Tube no Denshi Mitsudo Seigyo", 2004 Nen<br>(Heisei 16 Nen) Shunki Dai 51 Kai Oyo<br>Butsurigaku Kankei Rengo Koenkai Koen Yokoshu,<br>28 March, 2004 (28.03.04), separate Vol.1, page<br>537, middle part, 29p-F-4 | 1-27 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Y.LI ; W.KIM ; Y.ZHANG ; M.ROLANDI ; D.WANG.** *J.Phys.Chem.B,* 2001, vol. 105, 11424-11431
- **Y.ZHANG ; Y.LI ; W.KIM ; D.WANG ; H.DAI.** *Appl.Phys.A,* 2002, vol. 74, 325-328
- **Y.LI ; J.LIU ; Y.WANG ; Z.L.WANG.** *Chem.Mater.,* 2001, vol. 13, 1008-1014
- **Y.MURAKAMI ; Y.MIYAUCHI ; S.CHIASHI ; S.MARUYAMA.** *Chem.Phys.Lett.,* 2003, vol. 377, 49-54
- **Y.MURAKAMI ; S.CHIASHI ; Y.MIYAUCHI ; M.HU ; M.OGURA ; T.OKUBO ; S.MARUYAMA.** *Chem.Phys.Lett.,* 2004, vol. 385, 298-303
- **K.HATA ; D.N.FUTABA ; K.MIZUNO ; T.NAMAI ; M.YUMURA ; S.IIJIMA.** *Science,* 2004, vol. 306, 1362-1364
- **E.W.WONG ; M.J.BRONIKOWSKI ; M.E.HOENK ; R.S.KOWALCZYK ; B.D.HUNT.** *Chem.Mater.,* 2005, vol. 17, 237-241
- **J.LIU ; A.G.RINGZLER ; H.DAI ; J.H.HAFNER ; R.K.BRADLEY ; P.J.BOUL ; A.LU ; T.IVERSON ; K.SHELIMOV ; C.B.HUFFMAN.** *Science,* 1998, vol. 280, 1253
- **P.V.KAMAT ; K.G.THOMAS ; S.BARAZZOUK ; G.GIRISHKUMAR ; K.VINODGOPAL ; D.MEISEL.** *J. Am. Chem. Soc.,* 2004, vol. 126, 10757
- **R.KRUPKE ; F.HENNRICH ; H.V.LOHNEYSEN ; M.M.KAPPES.** *Science,* 2003, vol. 301, 344
- **D.L.FAN ; F.Q.ZHU ; R.C.CAMMARATA ; C.L.CHIEN.** *Appl. Phys. Lett.,* 2004, vol. 85, 4175
- **C.K.M.FUNG ; V.T.S.WONG ; R.H.M.CHAN ; W.J.LI.** *IEEE Transactions on Nanotechnology,* 2004, vol. 3, 395

- **Z.CHEN ; W.HU ; J.GUO ; K.SAITO.** *J. Vac. Sci. Technol. B,* 2004, vol. 22, 776
- **Z.CHEN ; Y.YANG ; Z.WU ; G.LUO ; L.XIE ; Z.LIU ; S.MA ; W.GUO.** *J. Phys. Chem. B,* 2005, vol. 109, 5743
- **D.S.LEE ; D.W.KIM ; H.S.KIM ; S.W.LEE ; S.H.JHANG ; Y.W.PARK ; E.E.B.CAMPBELL.** *Appl. Phys. A,* 2005, vol. 80, 5
- **Z.CHEN ; Y.YANG ; F.CHEN ; Q.QING ; Z.WU ; Z.LIU.** *J.Phys.Chem.B,* 2005, vol. 109, 11420
- **J.LIU ; M.J.CASAVANT ; M.COX ; D.A.WALTERS ; P.BOUL ; W.LU ; A.J.RIMBERG ; K.A.SMITH ; D.T.COLBERT ; R.E.SMALLEY.** *Chem. Phys. Lett.,* 1999, vol. 303, 125
- **M.-S.JUNG ; Y.-K.KO ; D.-H.JUNG ; D.-H.CHOI ; H.-T.JUNG ; J.-N.HEO ; B.-H.SOHN ; Y.-W.JIN ; J.KIM.** *Appl.Phys.Lett.,* 2005, vol. 87, 013114
- **L. DONG ; V. CHIRAYOS ; J. BUSH ; J.JIAO ; V.M.DUBIN ; R.V.CHEBIAN ; Y.ONO ; J.F.CONLEY JR ; B.D.ULRICH.** *J.Phys.Chem.B,* 2005, vol. 109, 13148
- **Y.MAEDA ; S.KIMURA ; M.KANDA ; Y.HIRASHIMA ; T.HASEGAWA ; T.WAKAHARA ; Y.LIAN ; T.NAKAHODO ; T.TSUCHIYA ; T.AKASAKA.** *J.Am.Chem.Soc.,* 2005, vol. 127, 10287
- **RI'ICHIRO SAITO ; HISANORI SHINOHARA.** Basics and applications of carbon Nanotubes. Baifukan, 2004
- **R. SAITO ; G. DRESSELHAUS ; M. S. DRESSELHAUS.** Physical Propertes of Carbon nanotubes. Imperial College Press, 1998